# EUROPEAN PATENT APPLICATION

(11) **EP 2 337 066 A1**
(43) Date of publication of application: **22.06.2011**
(21) Application number: 09290949.8
(22) Date of filing: 15.12.2009
(51) Int. Cl.: H01L 21/66

(54) **Method for making a semiconductor device by laser irradiation**

(71) Applicant: Excico France, 92230 Gennevilliers (FR)
(72) Inventor: Rack, Simon, 1340 Ottignies (BE)
(74) Representative: BiiP cvba

(57) **Abstract**

The present invention is related to a method for making a semiconductor device comprising the steps of: exposing a semiconductor substrate to a process step or sequence of process steps of which at least one process performance parameter is determined in a region of the semiconductor substrate, and irradiating the region with a laser having laser irradiation parameters; **characterized in that** the irradiation parameters are determined based on the at least one process performance parameter.

## Description

### FIELD OF THE INVENTION

The present invention relates to a method of making a semiconductor device by using laser irradiation.

### BACKGROUND OF THE INVENTION

In semiconductor processing, conventional methods for making a semiconductor device comprise a sequence of process steps such as deposition, lithography, etching, ion implantation, etc to obtain the semiconductor device.

Each process step in such sequence is specified by specific process performance parameters indicating the performance of the process and/or its limitations. For example, an ion implantation step can be specified amongst others by implantation dose, implantation depth, implantation energy, implanted dopant concentration, active dopant concentration, defect density, and resistivity or sheet resistance. Furthermore, since all process steps suffer from a certain degree of process variability, the mentioned parameters all have its equivalent within-wafer uniformity parameter and wafer-to-wafer uniformity parameter.

A general problem within semiconductor processing is that, even if every process step is performing at minimum process performance variability, the sequence of process steps suffers from cumulative process performance variability such that a percentage of the semiconductor devices obtained are not within specifications or show unreliable electronic performance, resulting in yield loss.

In an attempt to solve the above problem, process tool manufacturers and process engineers try to ensure as much as possible that every individual process tool or step performs with the best possible within-wafer uniformity, and with the best possible wafer-to-wafer repeatability by eliminating as much process performance variability as possible.

The above solution is logical and powerful, as long as process tolerances remain greater than the limits of process capability, which is a technical term used in Statistical Process Control to describe the characteristic random variation in a process, in other words the process performance when as many sources of systematic variation as possible have been eliminated.

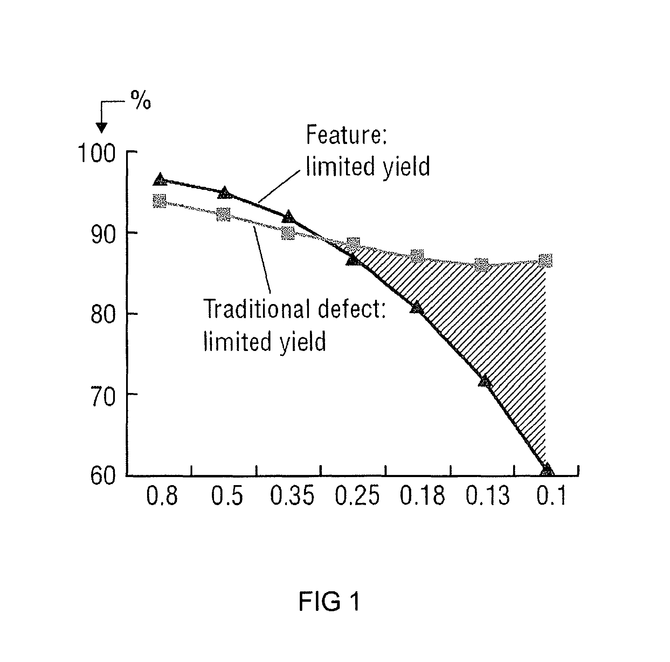

However, a further general problem is that due to continuously shrinking device dimensions, process parameter tolerances are continuously narrowed. Since these performance parameter tolerances move closer to process limitations, i.e. to what the process tools are capable of, yield loss caused by so-called parametric yield loss, is becoming more and more important. This is illustrated in FIG 1, showing 'classic' defect-limited yield and feature-limited yield as function of technology node (feature size). This establishes the increasing importance of parametric yield loss compared to defect-related yield loss.

Furthermore, processes in which all systematic process performance variability is eliminated, will generally still show small but highly unpredictable process performance variability, resulting in remaining quasi-random within-wafer uniformity parameters and wafer-to-wafer uniformity parameters.

Another problem still remaining is that, since generally a process tool is optimized in view of best possible within-wafer uniformity, it is much more difficult to optimize a process step in view of best possible wafer-to-wafer uniformity, whereas the within-wafer uniformity patterns may be very different from one wafer to another.

Considering the above drawbacks, there is a clear need for a method for making a semiconductor device which as a first object provides the ability to decrease parametric yield loss, in particular when process tolerances are required beyond the limits of process capability.

Further, it is an object of the present invention to provide a method for making a semiconductor device able to deal with quasi-random within-wafer uniformity parameters and wafer-to-wafer uniformity parameters due to unpredictable process performance variability.

Still another object of the present invention is to provide a method for making a semiconductor device which is optimized not only with respect to within-wafer uniformity parameters, but also with respect to wafer-to-wafer uniformity parameters.

In general it is an object of the present invention to increase process yield in the production of semiconductor devices, to minimize the number of produced devices out of specifications or showing unreliable electronic performance, and to improve device performance parameter distribution.

The present invention meets the above objects by providing a method comprising laser irradiation wherein the irradiation parameters are determined based on at least one process performance parameter of a prior process step or sequence of prior process steps.

### SUMMARY OF THE INVENTION

The present invention is directed to a method for making a semiconductor device comprising the steps of:
- exposing a semiconductor substrate to a process step or sequence of process steps of which at least one process performance parameter is determined,
- and irradiating a region of the semiconductor substrate with a laser having laser irradiation parameters;
**characterized in that** the irradiation parameters are determined based on the at least one process performance parameter.

### BRIEF DESCRIPTION OF THE DRAWINGS

FIG 1 illustrates yield issues in IC design as a function of technology node (Source: Kohyama/Toshiba).
FIG 2 illustrates an embodiment of method according to the present invention.
FIG 3 schematically shows an example of a method in accordance with the present invention.

### DESCRIPTION OF THE INVENTION

According to a first embodiment of the present invention a method for making a semiconductor device is provided comprising the steps of:
- exposing a semiconductor substrate to a process step or sequence of process steps of which at least one process performance parameter is determined in a region of the semiconductor substrate,
- and irradiating the region with a laser having laser irradiation parameters;
**characterized in that** the irradiation parameters are determined based on the at least one process performance parameter.

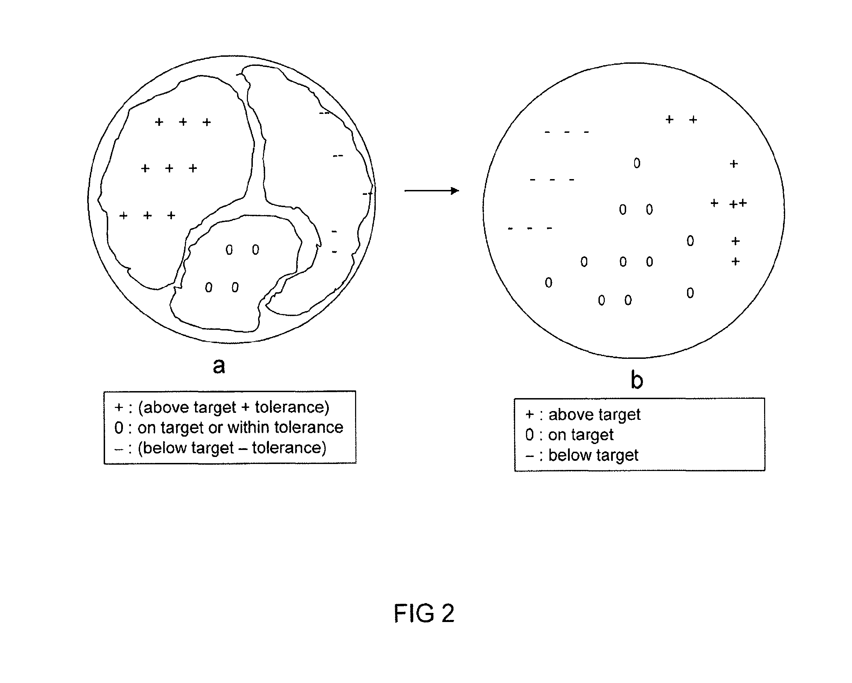

By determining at least one process performance parameter (FIG 2 (a)) of a process step or sequence of process steps, and determining the irradiation parameters (FIG 2 (b)) based on that process performance parameter, a region having a process performance parameter value above or below tolerance may be compensated by exposure to laser irradiation in order to achieve the corresponding target parameter value. Clearly, this may result in an increase of process yield and minimization of the number of produced devices out of specifications or showing unreliable electronic performance.

Another benefit of the present invention is that it may be used to fine-tune process performance parameters which are already within tolerances, thereby improving device performance parameter distribution.

Further, a method in accordance with the present invention may have the ability to decrease parametric yield loss. In particular when process parameter tolerances are required beyond the limits of process capability, laser irradiation may be used to compensate and reach those tolerances.

Still another benefit of determining the irradiation parameters based on one or more process performance parameters is that also unpredictable process performance variability may be compensated.

Laser irradiation of semiconductor substrates is well known for applications such as thermal annealing of amorphous silicon to obtain re-crystallization, and/or dopant activation. This technique offers significant advantages over a conventional heating process by enabling a fast local heat treatment, as illustrated for example in US 2004/0115931 describing a method comprising one or more annealing processes on one or more portions of a semiconductor device wherein the processes are varied based on one or more desirable characteristics of the annealed portion of the semiconductor device. However, determining irradiation parameters to be applied on a region of the semiconductor substrate based on the process performance variability of another process step or the cumulative process performance variability of a sequence of process steps was never suggested in the state of the art.

The irradiation parameters of the laser, such as wavelength, energy and pulse duration, are to be adapted as determined based on one or more process performance parameters of a process step or sequence of process steps. This may preferably be done by adjusting the output energy of the laser and/or the pulse length. For example, in case the laser is an excimer laser, the voltage applied to the gas discharge may be changed.

The irradiation parameters influence directly the heating temperature, temperature budget, heating depth or melt depth of the irradiated region, thereby directly or indirectly influencing the physical, dimensional, morphological or electrical characteristics of that region, providing the ability to compensate for limited process capability or process performance variability.

In the context of the present invention, the irradiated region of the semiconductor substrate may be of any material suitable for semiconductor applications such as, but not limited to undoped silicon, doped silicon, implanted silicon, crystalline silicon, amorphous silicon, silicon germanium, germanium nitride, III-V compound semiconductors such as gallium nitride, silicon carbide, and the like.

In an embodiment of the present invention, the laser used may be any laser whose wavelength, energy and pulse duration can be used for sufficiently heating and/or melting the semiconductor substrate, preferably an excimer laser and even more preferably a xenon chloride excimer laser.

Preferably the laser may irradiate in near-UV, more preferably having a wavelength of 308 nm.

The laser irradiation may be pulsed laser irradiation, having an aerial energy density of 0,1 to 6 J/cm², preferably 0.2 to 3 J/cm², and delivered pulse energy of 1 to 50 Joules. Use of a high energy laser allows processing of large areas with each laser pulse.

The pulse duration may be between 50 to 250 nanoseconds.

The laser beam spot size may be adapted or even matched to the region size to be irradiated, for example by using a variable aperture in the laser beam path, by using an optical system with variable beam spot magnification or a combination of both.

The at least one process performance parameter may comprise a dimensional, morphological, or electrical parameter, or a combination thereof.

The dimensional parameters may be but are not limited to substrate thickness, deposition rate, etch rate, implantation depth, gate length, and its equivalent uniformity parameters.

The morphological parameters may be but are not limited to crystallinity, grain size, defect density, lattice constant, strain level, relaxation degree, and its equivalent uniformity parameters.

The electrical parameters may be but are not limited to implantation density, implantation dose, dopant concentration, active dopant concentration, resistivity, sheet resistance, and its uniformity parameters.

In an embodiment according to the present invention, the at least one performance parameter may comprise a within-substrate non-uniformity parameter.

In a particular embodiment according to the present invention, the at least one performance parameter may comprise an substrate-to-substrate non-uniformity parameter.

By determining the irradiation parameters based on substrate-to-substrate non-uniformity parameters, process parameter variability in both the distribution over the semiconductor substrate, i.e. the distribution pattern, and the magnitude of substrate-to-substrate process parameter variability are explicitly taken into account prior to processing. The laser irradiation process is thereby adapted on a dimensional scale much smaller than the substrate dimensions, providing the ability to not only irradiate each substrate region with separately determined irradiation parameter, but even fine-tune process performance parameters within a region.

In an embodiment in accordance with the present invention, a method for making a semiconductor device is provided, wherein each region may be preliminary irradiated with common irradiation parameters before irradiating them with separately determined irradiation parameters.

In another embodiment according to the present invention, in each region the at least one process performance parameter and the irradiation parameters may be determined sequentially. Preferably, in this case the laser irradiation equipment itself will comprise means to measure a process performance parameter value of a region and calculation means to determine a set of irradiation parameters for that region. Alternatively and as illustrated also in FIG 2, a pattern of irradiation parameters may be determined based on a forwarded pattern of the at least one process performance parameter values. Such pattern containing at least one process performance parameter value per region of the semiconductor substrate may preferably be measured by dedicated metrology equipment forwarding the pattern as a whole to the laser irradiation equipment comprising calculation means to determine at least one set of irradiation parameters for each region.

In a particular embodiment of a method in accordance with the present invention, the step of exposing the semiconductor substrate to a process step or sequence of process steps of which at least one process performance parameter is determined in a region of the semiconductor is performed after the step of irradiating the region, and the forwarded pattern is an estimated pattern of the at least one process performance parameter. Such embodiment is illustrated in example 2.

The method of the present invention may be used for making semiconductor substrate, such a substrates and devices, an may be applied for example in:
- Compensating for crystallinity in a region being out of tolerances, caused by for example deposition process variability, by recrystallizing the region
- Compensating for defect density in a region being out of tolerances, caused by for example implantation, by recrystallizing the region
- Compensating for strain in a region being out of tolerances by heating and thereby modifying relaxation in the region.
- Compensating for active dopant concentration in a region being out of tolerances, by heating the region.
- Compensating for a device parameter (e.g. threshold voltage)being out of tolerances due to dimensional parameter variability, by additionally adapting the appropriate active dopant concentrations: see example 1.
- Compensating for variations in optical properties of silicon opto-devices.
- Changing alloy composition in contacts by local diffusion in order to compensate for silicidation process variability.

### EXAMPLE 1:

A particular example of the present invention is the following:

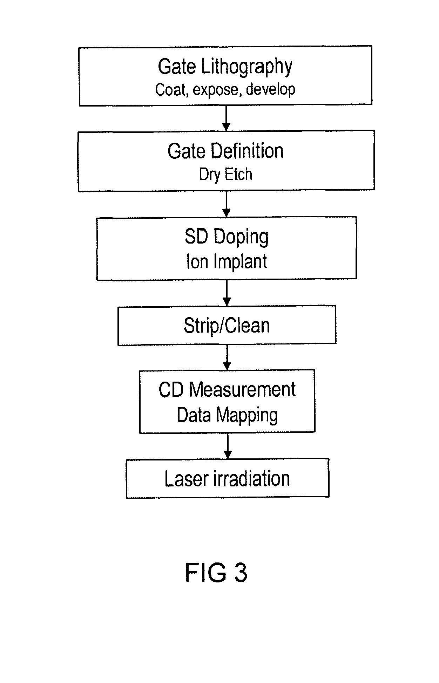

As illustrated in FIG 3, the gate of semiconductor device is formed by a sequence of processes, namely lithography, gate definition including dry etch, doping by ion implantation, stripping and cleaning. Finally a CD measurement is performed to determine the gate length critical dimension.

Two key semiconductor device parameters are Threshold Voltage (V_{TO}) and Drive current (I_{DSAT}). V_{TO} is sensitive to variations in a number of parameters, notably gate length and various doping concentrations, wherein gate length is directly dependent on the as-printed critical dimensions (CD) and the CD-loss due to process variability of the sequence of gate forming process steps.

Since the doping concentrations influencing the V_{TO} are directly dependent on the implanted dose and the annealing conditions, the variability in gate CD can be compensated by appropriately varying the laser irradiation conditions, thereby adapting the appropriate active dopant concentrations.

### EXAMPLE 2:

As an alternative to a method as described in example 1 wherein the variability in gate CD is compensated by subsequent laser dopant activation based on previous CD measurement, variability in gate CD may also be compensated by laser dopant activation in the n- and p-well regions before forming the gate, based on the estimation of future gate deposition process variability.

## Claims

1. A method for making a semiconductor device comprising the steps of
- exposing a semiconductor substrate to a process step or sequence of process steps of which at least one process performance parameter is determined in a region of the semiconductor substrate,
- and irradiating the region with a laser having laser irradiation parameters;
**characterized in that** the irradiation parameters are determined based on the at least one process performance parameter.

2. A method according to claim 1, wherein the at least one process performance parameter comprises a dimensional, morphological, or electrical parameter, or a combination thereof.

3. A method according to claim 2, wherein the at least one performance parameter comprises a within-substrate non-uniformity parameter.

4. A method according to claims 2 to 3, wherein the at least one process performance parameter comprises an substrate-to-substrate non-uniformity parameter.

5. A method according to claim 4, wherein at least two regions of the semiconductor substrate are irradiated and wherein for each region the irradiation parameters are separately determined.

6. A method according to claim 5, wherein each region is preliminary irradiated with common irradiation parameters before irradiating them with separately determined irradiation parameters.

7. A method according to claims 1 to 6, wherein for each region the at least one process performance parameter and the irradiation parameters are determined sequentially.

8. A method according to claims 1 to 6, wherein a pattern of irradiation parameters is determined based on a forwarded pattern of the at least one process performance parameter.

9. A method according to claim 8, wherein the step of exposing the semiconductor substrate to a process step or sequence of process steps of which at least one process performance parameter is determined in a region of the semiconductor is performed after the step of irradiating the region, and wherein the forwarded pattern is an estimated pattern of the at least one process performance parameter.

10. A method according to any of the above claims wherein the irradiation parameters are determined by a device CD.

11. A method according to any of the above claims, wherein the irradiation parameters are determined by a dopant concentration and an active dopant concentration to be achieved in the region.

12. A method according to any of the above claims, wherein the irradiation parameters are determined by strain and a degree of relaxation to be achieved in the region.

13. A method according to any of the above claims, wherein the irradiation parameters are determined by the thickness of a deposited layer.
